# EUROPEAN PATENT APPLICATION

(11) **EP 1 577 026 A2**
(43) Date of publication of application: **21.09.2005**
(21) Application number: 05005771.0
(22) Date of filing: 16.03.2005
(51) Int. Cl.: B08B 5/02, B41F 23/00, G03C 1/74

(54) **Method and device for removing dust from surface of support**

(30) Priority: 18.03.2004 JP 2004078451
(71) Applicant: FUJI PHOTO FILM CO., LTD., Kanagawa (JP)
(72) Inventor: MANDAI, Toshihiro, Kanagawa (JP); ISOZAKI, Hideo, Kanagawa (JP)
(74) Representative: Grünecker, Kinkeldey, Stockmair & Schwanhäusser Anwaltssozietät

(57) **Abstract**

According to the method and device of the present invention, the clean gas is supplied between the support (W) and the plate-like body (18, 20, 22, 120, 220) to form the pressurized space, thereby preventing the surface of the support (W) from being exposed to dust and allowing a conveyance path to be maintained at desired cleanliness. Specifically, the pressurized space between the support (W) and the plate-like body (18, 20, 22, 120, 220) is at the atmospheric pressure or higher, thereby preventing dust from being introduced.

## Description

### BACKGROUND OF THE INVENTION

### 1. Field of the Invention

The present invention relates to a method and a device for removing dust from a surface of a support, and more particularly to a method and a device for removing dust from a surface of a support that is conveyed through a conveyance path such as a coating line or a printing line that requires high cleanliness.

### 2. Related Art

A conveyance path of a coating line in which a coating liquid containing water or a solution as a solvent such as a photosensitive liquid, a magnetic fluid, or a solution coating is applied to a band-like flexible support (hereinafter referred to as a "web") and dried requires high cleanliness because the web is most likely to be exposed to dust in the conveyance path. Thus, a room in which the coating line is placed has been designed to be a clean room.

In this case, however, the entire room must be designed to be a clean room, thereby increasing construction costs. Also, ventilation by clean air must be provided in the entire room, which requires a large amount of clean air, thereby increasing running costs.

To solve these problems, the entire coating line is surrounded by a casing, and clean air is supplied into the casing to reduce a capacity required for ventilation. The method of surrounding the entire coating line by the casing can reduce costs as compared with the case where the entire room is designed to be a clean room, but in the casing, a bearing, a slide rail, a rack, an elevator, an air cylinder, or the like that generate dust are provided in addition to a web or a roll, and in some cases, a drive unit such as a motor, a belt, a gear, or a coupling is provided. These devices generate dust, and dust is also accumulated on the devices, which prevents an increase in cleanliness.

Further, a dead zone through which no clean air flows is likely to be formed. Thus, even by the method of surrounding the entire coating line by the casing, the web is most likely to be exposed to dust, and a conveyance path that requires high cleanliness cannot be maintained at desired cleanliness.

In view of such circumstances, the applicant of the invention has proposed a dust removing device for a subject to be conveyed capable of efficiently removing dust at low costs (see Japanese Patent Application Laid-open No. 2003-26326). This device is adapted to surround a conveyance path of a web only to maintain cleanliness near the web, and it is confirmed that a certain advantage can be obtained by the device.

### SUMMARY OF THE INVENTION

However, even with such a device, the surrounding of the conveyance path must be opened for handling in such a case when the web is cut, which may reduce cleanliness near the web to contaminate the web.

The invention has been achieved in view of the above described circumstances, and has an object to provide a method and a device for removing dust from a surface of a support capable of efficiently removing dust at low costs from a subject to be conveyed (a support) that is conveyed through a conveyance path provided in an anti-dust line that is sensitive to dust such as a coating line or a printing line.

In order to achieve the object, the invention provides a method for removing dust from a surface of a support, comprising the steps of: placing a plate-like body on a surface of a traveling band-like support so as to face the surface at a predetermined distance; supplying a gas with cleanliness of class 10 or less between the support and the plate-like body; and forming a pressurized space at atmospheric pressure or higher between the support and the plate-like body, and a device for the method.

According to the invention, the clean gas is supplied between the support and the plate-like body to form the pressurized space, thereby preventing the surface of the support from being exposed to dust and allowing a conveyance path to be maintained at desired cleanliness. Specifically, the pressurized space between the support and the plate-like body is at the atmospheric pressure or higher, thereby preventing dust from being introduced.

The conveyance path in which the support is most likely to be exposed to dust may have a small capacity, thereby preventing reduction in speed of the clean gas and preventing a dead zone in which no clean gas flows from being formed. This allows dust to be effectively removed from the support with a small amount of clean gas. The conveyance path in which the support is most likely to be exposed to dust can be maintained at the desired cleanliness, thereby reducing an amount of clean gas used for the entire anti-dust line.

As the support, the band-like flexible support (web) as described above is generally used, but the advantage of the invention may be obtained with a plate-like body such as a glass substrate or a silicone wafer.

As the clean gas, clean air is generally used, but gases such as a nitrogen gas or an argon gas may be used.

In the invention, it is preferable that a width of the plate-like body is equal to or larger than a width of the support, a slit is formed in the plate-like body in a traveling direction of the support, and the gas with the cleanliness of class 10 or less is supplied through the slit. With such a configuration, the clean gas supplied through the slit in the plate-like body forms the pressurized space to allow the conveyance path to be maintained at desired cleanliness.

In the invention, it is preferable that a width of the plate-like body is equal to or larger than a width of the support, a slit is formed in the plate-like body perpendicularly to a traveling direction of the support, and the gas with the cleanliness of class 10 or less is supplied through the slit. With such a configuration, the clean gas supplied through the slit in the plate-like body forms the pressurized space to allow the conveyance path to be maintained at desired cleanliness.

In the invention, it is preferable that a width of the plate-like body is equal to or larger than a width of the support, multiple air supply holes are formed in the plate-like body, and the gas with the cleanliness of class 10 or less is supplied through the air supply holes. With such a configuration, the clean gas supplied through the multiple air supply holes forms the pressurized space to allow the conveyance path to be maintained at desired cleanliness.

In the invention, it is preferable that a width of the plate-like body is equal to or larger than a width of the support, a surface of the plate-like body is formed of a permeable member, and the gas with the cleanliness of class 10 or less is supplied through the permeable member. With such a configuration, the clean gas supplied through the surface of the plate-like body that is the permeable member forms the pressurized space to allow the conveyance path to be maintained at desired cleanliness.

In the invention, it is preferable that the pressurized space at atmospheric pressure or higher is formed between a coating side surface of the support and the plate-like body before and/or after a coating film with a thickness at coating of 10 µm or less is formed on the surface of the support by a coating device. The pressurized space is formed in the conveyance path before and after the coating device to provide an advantage of an anti-dust line.

In the invention, it is preferable that the pressurized space at atmospheric pressure or higher is formed between the support and the plate-like body after the surface of the support is cleaned. The pressurized space is formed in the conveyance path after the cleaning (dust removing) to provide an advantage of the anti-dust line. As a device for "cleaning the surface of the support", various types of known devices may be used such as a high speed air blow device with ultrasonic sounds, an adhesive roller, or a round bar immersed in a solution.

As described above, according to the invention, the clean gas is supplied between the support and the plate-like body to form the pressurized space, thereby preventing the surface of the support from being exposed to dust and allowing the conveyance path to be maintained at desired cleanliness.

### BRIEF DESCRIPTION OF THE DRAWINGS

Fig. 1 illustrates a film manufacturing line to which the invention is applied;
Fig. 2 is a perspective view of a dust removing conveyance path;
Fig. 3 is an enlarged perspective view of essential portions showing a relationship between a web and a plate-like body;
Fig. 4 is a perspective view, partially broken away, of a configuration of a coating head;
Fig. 5 is an enlarged perspective view of essential portions showing a relationship between a web and a plate-like body in another example;
Fig. 6 is an enlarged perspective view of essential portions showing a relationship between a web and a plate-like body in a further example;
Fig. 7 is a table showing evaluation results of an example; and
Fig. 8 is a table showing evaluation results of an example.

### DETAILED DESCRIPTION OF THE PREFERRED EMBODIMENTS

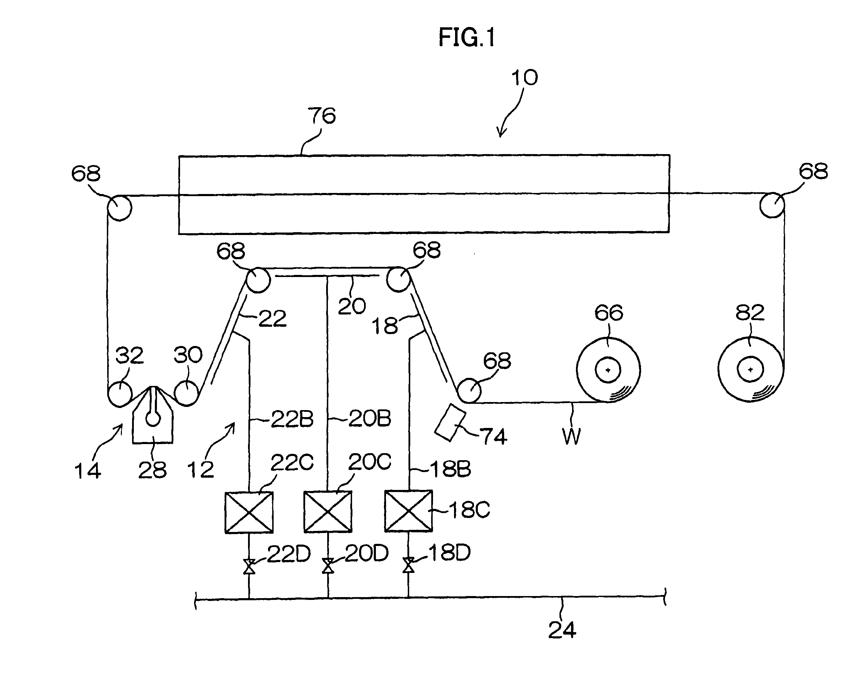

Now, a preferred embodiment (a first embodiment) of a method and a device for removing dust from a surface of a support according to the invention will be described in detail with reference to the accompanying drawings. Fig. 1 illustrates a film manufacturing line to which the method and the device for removing dust from a surface of a support according to the invention is applied.

In a film manufacturing line 10, a web W is fed from a feeder 66 as shown in Fig. 1. The web W is guided by a guide roller 68 and fed into a dust removing conveyance path 12. A dust remover 74 is provided upstream of the dust removing conveyance path 12, and can remove dust deposited on a surface of the web W. The dust removing conveyance path 12 will be described later in detail.

A coating device 14 is provided downstream of the dust removing conveyance path 12, and can apply a coating liquid to the web W. The coating device 14 is an extrusion-type coater. A drying zone 76 is provided downstream of the coating device 14, and can dry a coating layer formed on the web W. Then, the web W on which the coating layer is formed is wound by a winder 82 provided downstream of the drying zone 76.

The dust remover 74 that is a device for cleaning the surface of the support includes a remover using a dry-type dust removing method and a remover using a wet-type dust removing method.

The dry-type dust removing method includes a method of pressing a nonwoven fabric or a blade on the surface of the web W, a method of blowing air with high cleanliness on the surface of the web W at high speed to peel deposits off the surface and sucking the deposits into an adjacent suction port for removal, and a method of bringing an adhesive roller into contact with the traveling web W and removing deposits on the surface of the web W.

The wet-type dust removing method includes a method of pressing a nonwoven fabric or a blade on the web W while a solution remains on the web W after the solution is applied thereto, or a method of pressing a rod member that rotates in an opposite direction from a conveying direction of the web W on the surface of the web W while a solution remains on the web W after the solution is applied thereto to scrape deposits off the surface.

Further, the applicant of the invention has proposed a method and a device for removing dust from a web including a combination of a dry-type dust removing method and a wet-type dust removing method (Japanese Patent Application Laid-open No. 2002-79200), and it is confirmed that a certain advantage can be obtained by the method and the device. Thus, such a method and a device for removing dust from a web may be used.

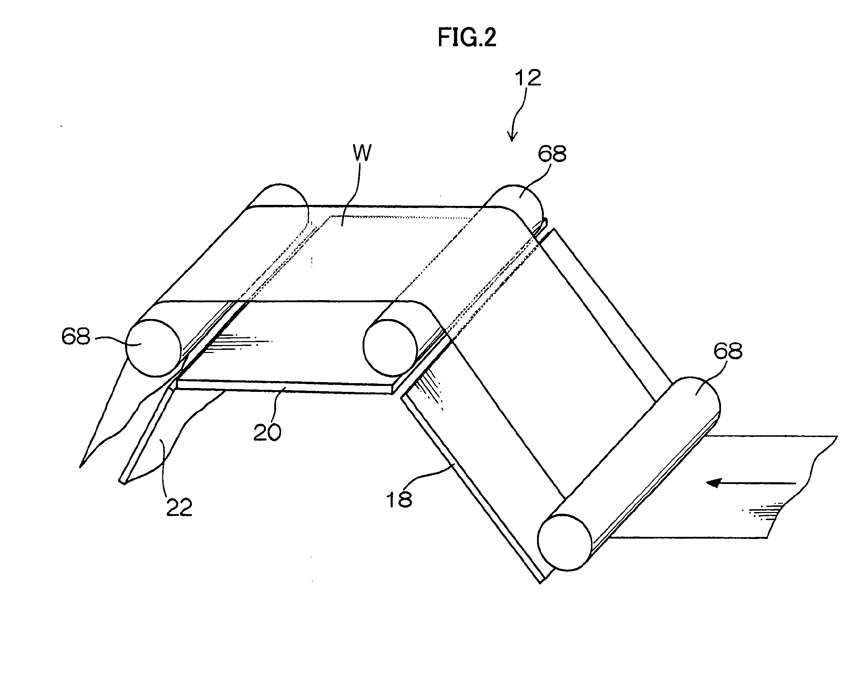

Next, the dust removing conveyance path 12 that is a characteristic feature of the invention will be described. Fig. 2 is a perspective view of the dust removing conveyance path 12 in the film manufacturing line 10 in Fig. 1. In Figs. 1 and 2, the dust removing conveyance path 12 is adapted so that plate-like bodies 18, 20 and 22 are placed so as to face, at a predetermined distance, the surface of the web W traveling in the direction of arrow, air with cleanliness of class 10 or less is supplied between the web W and the plate-like bodies 18, 20 and 22, and a pressurized space at atmospheric pressure or higher is formed between the web W and the plate-like bodies 18, 20 and 22.

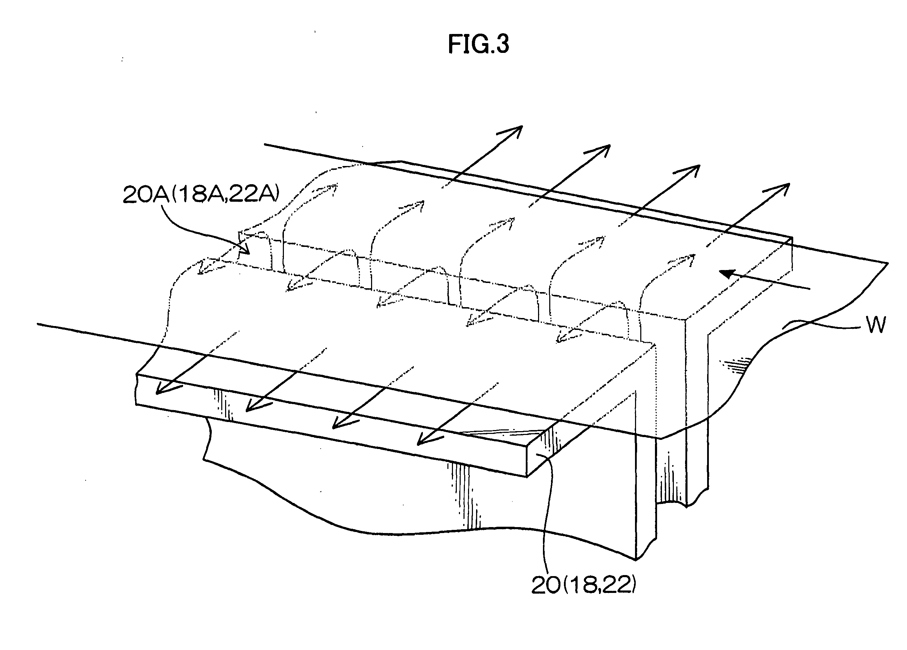

Fig. 3 is an enlarged perspective view of essential portions of a relationship between the web W and the plate-like body 20 (18, 22). A width of the plate-like body 20 (18, 22) is larger than a width of the web W, a slit 20A (18A, 22A) is formed in a surface of the plate-like body 20 (18, 22) in the traveling direction of the web W, and the air with the cleanliness of class 10 or less (hereinafter referred to as "clean air") is supplied through the slit 20A (18A, 22A).

The clean air hits the surface (a lower surface) of the web W at a position facing the slit 20A (18A, 22A), and is divided into right and left sides to flow in the directions of arrows and flow outside from edges of the web W. The flow of the clean air forms the pressurized space at atmospheric pressure or higher between the web W and the plate-like body 20 (18, 22), thereby preventing the surface (lower surface) of the web W from being exposed to dust and allowing the dust removing conveyance path 12 to be maintained at high cleanliness.

As shown in Fig. 1, in order to supply the clean air through the slit 20A (18A, 22A), clean air pipes 18B, 20B and 22B are connected to the plate-like bodies 18, 20 and 22, respectively, air supply devices with filters 18C, 20C and 22C are connected to the upstream sides of the clean air pipes 18B, 20B and 22B, respectively, valves 18D, 20D and 22D are connected to the upstream sides of the air supply devices with filters 18C, 20C and 22C, respectively, and the upstream sides of the valves 18D, 20D and 22D are connected to one air supply pipe 24.

In the dust removing conveyance path 12, values such as a size and a material of the plate-like body 20 (18, 22), a size of the slit 20A (18A, 22A), the distance between the web W and the plate-like body 20 (18, 22), and a flow rate of the clean air are appropriately determined depending on a conveying speed of the web W, a substance of the coating liquid, a thickness of the coating film, specifications of a product, required cleanliness, or the like.

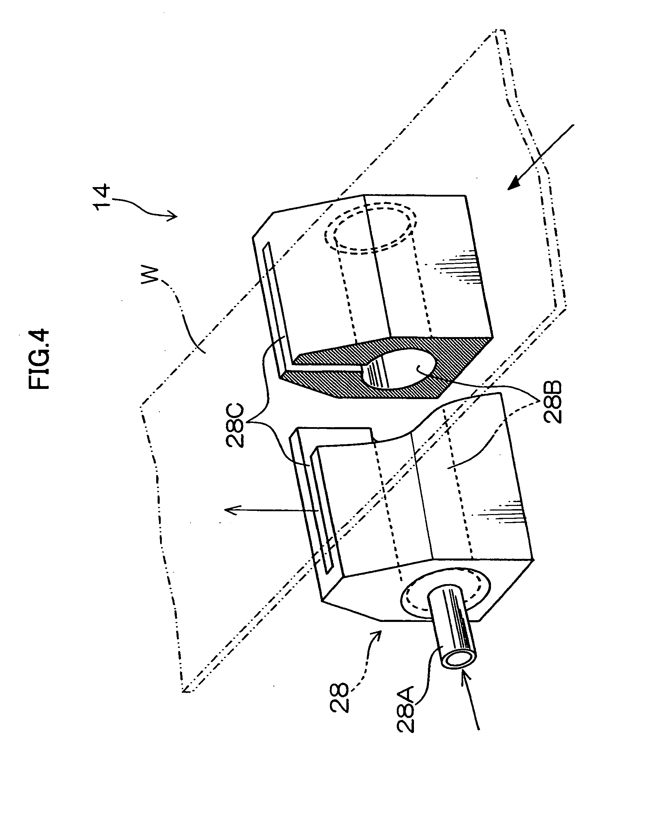

Next, a coating device 14 placed downstream of the dust removing conveyance path 12 will be described. Fig. 4 is a perspective view, partially broken away, of a configuration of a coating head 28 that is an essential portion of the coating device 14.

The coating head 28 is placed in such a manner that a tip of the coating head closely faces the continuously traveling web W. Specifically, as shown in Fig. 1, the web W is wound around guide rollers 30 and 32 placed before and after the coating device 14 and supported with the surface (lower surface) thereof being close to the tip of the coating head 28.

As shown in Fig. 4, in the coating head 28, a cylindrical pocket 28B is formed in parallel with the width of the web W, and the coating pocket 28B is connected to a supply line 28A. Also in the coating head 28, a coating slit 28C having a discharge port at the tip of the coating-head is formed; and communicates with the coating pocket 28B.

The coating slit 28C is a narrow passage connecting the pocket 28B and the tip of the coating head, and is extended along the width of the web W. Then, a coating liquid of a desired coating amount to be applied to the web W is supplied from the supply line 28A to the coating pocket 28B of the coating head 28.

In Fig. 4, the coating liquid is supplied into the pocket 28B from one side of the coating pocket 28B, but the coating liquid may be supplied from one side of the coating pocket 28B and drawn out of the other side thereof, or the coating liquid may be supplied from a middle of the coating pocket 28B and divided into both sides.

The coating device 14 in Fig. 4 is illustrated by way of example, and coating devices of other types may be used such as a bar coater (also referred to as a "rod coater" and including a Mayor bar coater), a gravure coater (such as a gravure kiss coater or a micro gravure coater), a roll coater (such as a transfer roll coater and a reverse roll coater), a dye coater, a fountain coater, a curtain coater, a dip coater, a spin coater, a spray coater, or a slide hopper.

Next, a film manufacturing method using the film manufacturing line in Fig. 1 will be described. First, the web W is fed from the feeder 66. The web W is guided by the guide roller 68, and dust deposited on the surface of the web W is removed by the dust remover 74.

Then, the web W is passed through the dust removing conveyance path 12 until the web W is conveyed to the coating device 14. In the dust removing conveyance path 12, the flow of the clean air forms the pressurized space at atmospheric pressure or higher between the web W and the plate-like bodies 18, 20 and 22, thereby preventing the surface (lower surface) of the web W from being exposed to dust and allowing the dust removing conveyance path 12 to be maintained at high cleanliness.

Then, the coating liquid is applied to the web W by the coating device 14. The web W is then passed through the drying zone 76 and wound by the winder 82.

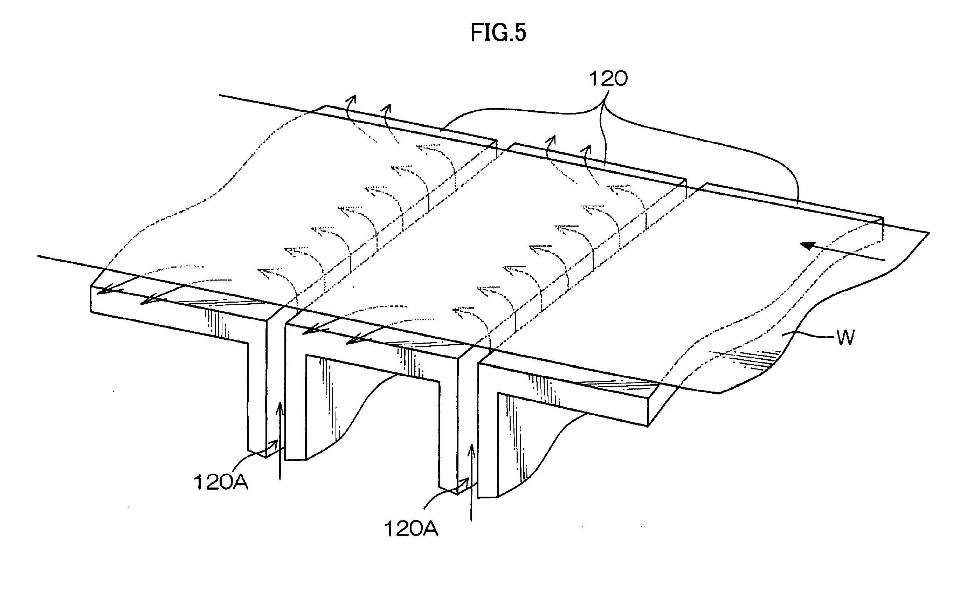

Next, a second embodiment of the invention will be described in detail. Fig. 5 is an enlarged perspective view of essential portions showing a relationship between a web W and a plate-like body in another example. The configuration of the above described film manufacturing line 10 in Fig. 1 and the configuration of the coating head 28 of the coating device 14 in Fig. 4 also apply to the second embodiment, and descriptions thereof will be omitted.

In Fig. 5, a width of a plate-like body 120 is larger than a width of the web W, slits 120A are formed in a surface of the plate-like body 120 perpendicularly to a traveling direction of the web W, and clean air is supplied through the slits 120A.

Next, a film manufacturing method in the second embodiment of the invention will be described. Components other than a dust removing conveyance path 12 are the same as those in the first embodiment, and thus the dust removing conveyance path 12 only will be described.

The web W is passed through the dust removing conveyance path 12 from a dust remover 74 to a coating device 14. In the dust removing conveyance path 12, the clean air hits a surface (a lower surface) of the web W at positions facing the slits 120A and 120A, flows together with the web W as shown by arrows, and is divided into right and left sides and flow outside from edges of the web W. The flow of the clean air forms a pressurized space at atmospheric pressure or higher between the web W and the plate-like body 120, thereby preventing the surface (lower surface) of the web W from being exposed to dust and allowing the dust removing conveyance path 12 to be maintained at high cleanliness.

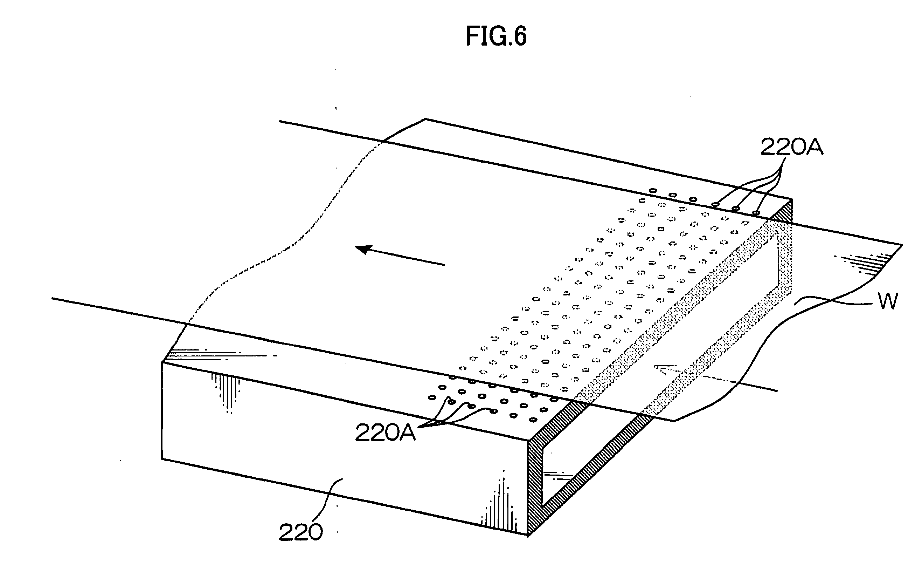

Next, a third embodiment of the invention will be described in detail. Fig. 6 is an enlarged perspective view, partially broken away, of essential portions showing a relationship between a web W and a plate-like body in a further example. The configuration of the above described film manufacturing line 10 in Fig. 1 and the configuration of the coating head 28 of the coating device 14 in Fig. 4 also apply to the third embodiment, and descriptions thereof will be omitted.

In Fig. 6, a width of a plate-like body 220 is larger than a width of the web W. Multiple air supply holes 220A are formed in a substantially entire surface of the plate-like body 220, and clean air is supplied through the air supply holes 220A. Specifically, the plate-like body 220 is hollow, and the clean air supplied from a clean air pipe 20B (see Fig. 1) into an inside of the plate-like body 220 is uniformly jetted from the multiple air supply holes 220A.

Next, a film manufacturing method in the third embodiment of the invention will be described. Components other than a dust removing conveyance path 12 are the same as those in the first embodiment, and thus the dust removing conveyance path 12 only will be described.

The web W is passed through the dust removing conveyance path 12 from a dust remover 74 to a coating device 14. In the dust removing conveyance path 12, the clean air hits a surface (a lower surface) of the web W, flows together with the web W as shown by arrows, and is divided into right and left sides to flow in the directions of arrows and flow outside from edges of the web W. The flow of the clean air forms a pressurized space at atmospheric pressure or higher between the web W and the plate-like body 220, thereby preventing the surface (lower surface) of the web W from being exposed to dust and allowing the dust removing conveyance path 12 to be maintained at high cleanliness.

The embodiments of the method and the device for removing dust from a surface of a support according to the invention have been described, but the invention is not limited to the embodiments, and various aspects may be adopted.

For example, in the embodiments, the three types of plate-like bodies 20, 120 and 220 have been described, but plate-like bodies having other configurations may be used. By way of example, a surface of a plate-like body may be formed of a permeable member so that a gas with cleanliness of class 10 or less is supplied through the permeable member. As such a permeable member, porous ceramics, porous fluororesin, or the like may be preferably used.

For the numbers or layouts of the plate-like bodies 20, 120 and 220, various configurations other than the embodiments may be used.

### [Example]

The film manufacturing line 10 in Fig. 1 was used to perform processing of the web W (application of the coating liquid or the like).

As the web W, a PET film having a width of 300 mm and a thickness of 10 µm was used. A traveling speed of the web W was fixed to 100 m/min.

The dust remover 74 used was of the type that blows air with high cleanliness on the surface of the W at high speed to peel deposits off the surface, and sucks the deposits into an adjacent suction port for removal.

Viscosity of the coating liquid applied by the coating device 14 was 0.02 Pas (20 cP), and a coating film thickness (a wet film thickness) was 8 µm.

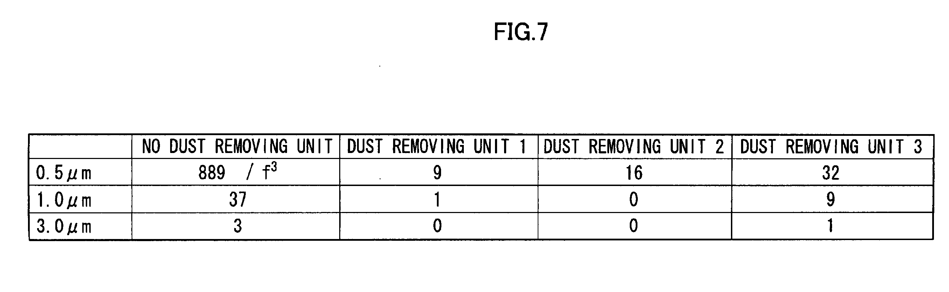

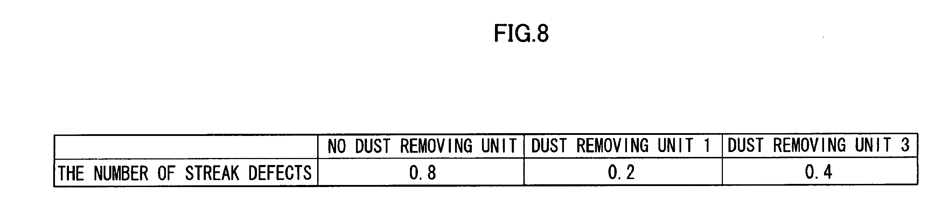

As the plate-like body used in the dust removing conveyance path 12, three types of plate-like bodies: the plate-like body 20 (18, 22) in Fig. 3, the plate-like body 120 in Fig. 5, and the permeable member instead of the plate-like body 220 in Fig. 6 were used. As a comparative example, a configuration using no plate-like body in the dust removing conveyance path 12 (indicated as "no dust removing unit" in below described tables in Figs. 7 and 8) was also used.

For the plate-like body 20 (18, 22) in Fig. 3, the material of the plate-like body 20 was stainless steel, and the width of the plate-like body 20 was larger than the width of the web W by 50 mm on each side. The distance between the web W and the plate-like body 20 was set to 50 mm. The width of the slit 20A placed in the center along the width of the web W was 2 mm. The speed of air blowing from the slit 20A was 5 m/sec. Evaluation results of the plate-like body 20 are indicated as "dust removing unit 1" in the below described tables in Figs. 7 and 8.

For the plate-like body 120 in Fig. 5, the material of the plate-like body 120 was stainless steel, and the width of the plate-like body 120 was larger than the width of the web W by 50 mm on each side. The distance between the web W and the plate-like body 120 was set to 50 mm. The clearance between the slits 120A in the plate-like body 120 was 200 mm. The width of the slit 120A was 2 mm. The speed of air blowing from the slit 20A was 5 m/sec. Evaluation results of the plate-like body 120 are indicated as "dust removing unit 2" in the below described tables in Figs. 7 and 8.

For the permeable member instead of the plate-like body 220 in Fig. 6, the material of the surface of the cylindrical plate-like body was polypropylene fiber (manufactured by Mitsubishi Rayon Co., Ltd.), the width of the plate-like body was 350 mm, and the height thereof was 200 mm. The distance between the web W and the plate-like body was set to 50 mm. The speed of air blowing from the surface of the plate-like body was 1.0 m/sec. Evaluation results of the plate-like body are indicated as "dust removing unit 3" in the below described tables in Figs. 7 and 8

As a method for evaluating advantages obtained by using various types of plate-like bodies in the dust removing conveyance path 12, measurement of cleanliness near the web W and determination of the presence of coating defects (streak defects) in the application of the coating liquid were used.

In the measurement of the cleanliness, a laser particle counted manufactured by Transtech Co., Ltd. was used to measure the number of dust particles having sizes from 0.5 to 3.0 µm. A summary of the measurement results of the cleanliness was provided in the table in Fig. 7.

The determination of the presence of the coating defects (streak defects) was performed by visual check. Streaks produced in a length of 10 m of the web W were counted under a halogen lamp, and an average value of five measurements was calculated to determine the presence of the defects. A summary of the average values of the streak defects was provided in the table in Fig. 8.

According to the table in Fig. 7, satisfactory cleanliness is obtained in the embodiments of the invention (i.e. "dust removing units 1 to 3") as compared with the comparative example (i.e. "no dust removing unit"). In particular, the number of dust particles having a minute size of 0.5 µm in the embodiments is about one-thirtieth to one-hundredth of the number in the comparative example.

According to the table in Fig. 8, the number of streak defects in the embodiments of the invention (i.e. "dust removing units 1 to 3") is one-half to one-quarter of the number in the comparative example (i.e. "no dust removing unit), and it can be confirmed that satisfactory cleanliness is maintained.

## Claims

1. A method for removing dust from a surface of a support (W), comprising the steps of:
placing a plate-like body (18, 20, 22, 120, 220) on a surface of a traveling band-like support (W) so as to face the surface at a predetermined distance;
supplying a gas with cleanliness of class 10 or less between the support (W) and the plate-like body (18, 20, 22, 120, 220); and
forming a pressurized space at atmospheric pressure or higher between the support (W) and the plate-like body (18, 20, 22, 120, 220).

2. The method for removing dust from a surface of a support (W) according to claim 1, wherein
a width of the plate-like body (18, 20, 22) is equal to or larger than a width of the support (W);
a slit (18A, 20A, 22A) is formed in the plate-like body (18, 20, 22) in a traveling direction of the support (W); and
the gas with the cleanliness of class 10 or less is supplied through the slit (18A, 20A, 22A).

3. The method for removing dust from a surface of a support (W) according to claim 1, wherein
a width of the plate-like body (120) is equal to or larger than a width of the support (W);
a slit (120A) is formed in the plate-like body (120) perpendicularly to a traveling direction of the support (W); and
the gas with the cleanliness of class 10 or less is supplied through the slit (120A).

4. The method for removing dust from a surface of a support (W) according to claim 1, wherein
a width of the plate-like body (220) is equal to or larger than a width of the support (W);
multiple air supply holes (220A) are formed in the plate-like body (220); and
the gas with the cleanliness of class 10 or less is supplied through the air supply holes (220A).

5. The method for removing dust from a surface of a support (W) according to claim 1, wherein
a width of the plate-like body is equal to or larger than a width of the support (W);
a surface of the plate-like body is formed of a permeable member; and
the gas with the cleanliness of class 10 or less is supplied through the permeable member.

6. The method for removing dust from a surface of a support (W) according to any one of claims 1 to 5, wherein the pressurized space at atmospheric pressure or higher is formed between a coating side surface of the support (W) and the plate-like body (18, 20, 22, 120, 220) before and/or after a coating film with a thickness at coating of 10 µm or less is formed on the surface of the support (W) by a coating device (14).

7. The method for removing dust from a surface of a support (W) according to any one of claims 1 to 6, wherein the pressurized space at atmospheric pressure or higher is formed between the support (W) and the plate-like body (18, 20, 22, 120, 220) after the surface of the support (W) is cleaned.

8. A device (12) for removing dust from a surface of a support (W), comprising:
a support conveying device (66, 68) which causes a band-like support (W) to travel;
a plate-like body (18, 20, 22, 120, 220) placed on a surface of the traveling support (W) so as to face the surface at a predetermined distance; and
a gas supply device (18C, 20C, 22C) which supplies a gas with cleanliness of class 10 or less between the support (W) and the plate-like body (18, 20, 22, 120, 220),
wherein a pressurized space at atmospheric pressure or higher is formed between the support (W) and the plate-like body (18, 20, 22, 120, 220).
